(19) Europäisches Patentamt
European Patent Office
Office européen des brevets

(11) **EP 1 560 261 A1**

(12) **EUROPEAN PATENT APPLICATION**
published in accordance with Art. 158(3) EPC

(43) Date of publication:
**03.08.2005 Bulletin 2005/31**

(51) Int Cl.$^7$: **H01L 21/306**, C30B 33/10

(21) Application number: **04735986.4**

(22) Date of filing: **03.06.2004**

(86) International application number:
**PCT/JP2004/008090**

(87) International publication number:
**WO 2004/112116 (23.12.2004 Gazette 2004/52)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **16.06.2003 JP 2003170584**

(71) Applicants:
• **Sumitomo Electric Industries, Ltd.**
  **Osaka-shi, Osaka 541-0041 (JP)**
• **Mori, Yusuke**
  **Katano-shi, Osaka 576-0033 (JP)**

(72) Inventors:
• **Nakahata, S.,**
  **c/o Itami Works of Sumitomo Electric**
  **Itami-shi, Hyogo 6648611 (JP)**

• **Hirota, R., c/o Itami Works of Sumitomo Electric**
  **Itami-shi, Hyogo 6648611 (JP)**
• **Ishibashi, K.,**
  **c/o Itami Works of Sumitomo Electr.**
  **Itami-shi, Hyogo 6648611 (JP)**
• **Sasaki, Takatomo**
  **Suita-shi, Osaka 5650824 (JP)**
• **Mori, Yusuke**
  **Katano-shi, Osaka 5760033 (JP)**

(74) Representative: **Grünecker, Kinkeldey,**
**Stockmair & Schwanhäusser Anwaltssozietät**
**Maximilianstrasse 58**
**80538 München (DE)**

(54) **METHOD FOR PROCESSING NITRIDE SEMICONDUCTOR CRYSTAL SURFACE AND NITRIDE SEMICONDUCTOR CRYSTAL OBTAINED BY SUCH METHOD**

(57)    A method of processing a surface of a nitride semiconductor crystal, wherein a surface of a nitride semiconductor crystal (11) is brought into contact with a liquid containing at least Na, Li or Ca as a processing solution (15). In the method, the processing solution (15) can be a liquid containing at least Na, having an Na content of 5-95 mol%. The processing solution (15) can be a liquid containing at least Li, having an Li content of 5-100 mol%. A nitride semiconductor crystal having a maximum depth of a surface scratch of at most 0.01 µm or an average thickness of a damaged layer of at most 2 µm. Consequently, a method of processing a surface of a nitride semiconductor crystal with a decreased depth of a surface scratch or a decreased thickness of a damaged layer, and a nitride semiconductor crystal obtained with the method can be provided.

FIG.1

**Description**

Technical Field

The present invention relates to a method of processing a surface of a nitride semiconductor crystal and a nitride semiconductor crystal obtained with the method. More specifically, the present invention relates to a method of processing a surface of a nitride semiconductor crystal with a decreased depth of a surface scratch or a decreased thickness of a damaged layer, and a nitride semiconductor crystal obtained with the method.

Background Art

Attention has been focused on a micromachining technique for a semiconductor crystal while higher integration of semiconductor devices has been performed. A technique for processing a semiconductor crystal to obtain a flat surface thereof (a planarization technique) is important as a basis of the micromachining technique for a semiconductor crystal.

In these days, a CMP (chemical mechanical polishing) method, that is, chemical and mechanical polishing using abrasive slurry consisting of an abrasive solution and abrasive grains is mainly used as a method for processing a semiconductor crystal to obtain a flat surface.

Though chemical surface processing is possible for a silicon crystal or the like which is chemically active (for example, it is soluble in hydrofluoric acid), a nitride semiconductor crystal such as a group III nitride semiconductor crystal is chemically inert (stable) and has a dependence on mechanical processing. The "mechanical processing" mentioned here means surface processing of a crystal in which abrasive grains are interposed between the crystal and a turn table (hereafter referred to as a "surface plate") and the surface plate is moved relative to the crystal to cut or polish a crystal surface with friction between the abrasive grains and the crystal surface.

During the mechanical processing, deep scratches are generated on the crystal surface with the abrasive grains, and a thick layer of a disordered crystal (hereafter referred to as a "damaged layer") is formed due to the friction between the crystal surface and the abrasive grains (see Yamamoto, *KESSHOU KOUGAKU HANDOBUKKU (Handbook of Crystal Engineering)*, first edition, Kyoritsu Shuppan Co. Ltd., September 25, 1990, pp. 421-423). Since existence of the deep scratch on the crystal surface or the thick damaged layer disturbs micromachining and degrades semiconductor characteristics, the scratch on the crystal surface and the damaged layer must be removed with further etching or the like.

Disclosure of the Invention

An object of the present invention is to provide a method of processing a surface of a nitride semiconductor crystal with a decreased depth of a surface scratch or a decreased thickness of a damaged layer, and a nitride semiconductor crystal obtained with the method.

To attain the above-described object, a method of processing a surface of a nitride semiconductor crystal according to the present invention is characterized in that, a surface of a nitride semiconductor crystal is brought into contact with a liquid containing at least Na, Li or Ca as a processing solution. The processing solution may be a liquid containing at least Na, which can have an Na content of 5-95 mol%. In addition, the processing solution may be a liquid containing at least Li, which can have an Li content of 5-100 mol%. An $Al_xGa_yIn_{1-x-y}N$ semiconductor crystal ($0 \leq x \leq 1$, $0 \leq y \leq 1$, $0 \leq x + y \leq 1$) or the like can be processed as the nitride semiconductor crystal.

In addition, a nitride semiconductor crystal according to the present invention is a nitride semiconductor crystal having a maximum depth of a surface scratch of at most 0.01 $\mu$m or an average thickness of a damaged layer of at most 2 $\mu$m, which is obtained with the above-described method of processing a surface of a nitride semiconductor crystal.

As described above, according to the present invention, a method of processing a surface of a nitride semiconductor crystal with a decreased depth of a surface scratch and a decreased thickness of a damaged layer as well as a nitride semiconductor crystal obtained with the method can be provided with a surface of a nitride semiconductor crystal being brought into contact with a liquid containing at least Na, Li or Ca as a processing solution.

Brief Description of the Drawings

Fig. 1 is a view for describing a method of processing a surface of a nitride semiconductor crystal according to the present invention.

Fig. 2 is a perspective cross-sectional view of a surface plate used in the present invention.
Fig. 3 is a perspective cross-sectional view of another surface plate used in the present invention.

Best Modes for Carrying Out the Invention

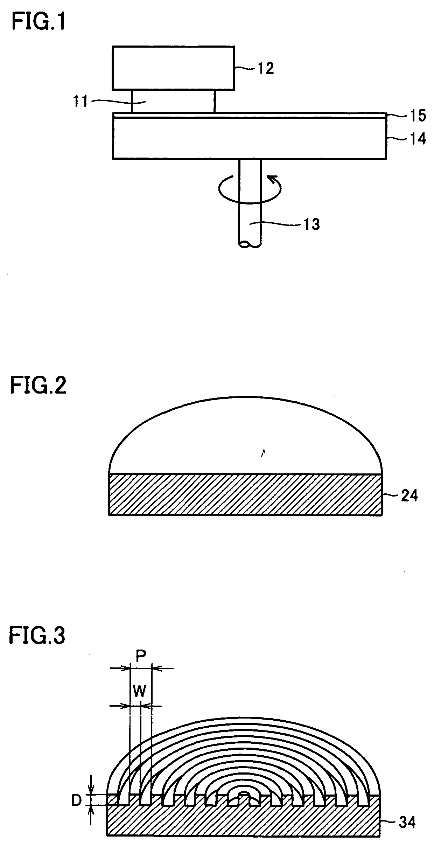

Referring to Fig. 1, a method of processing a surface of a nitride semiconductor crystal according to the present invention is characterized in that, a surface of a nitride semiconductor crystal 11 is brought into contact with a liquid containing at least Na, Li or Ca as a processing solution 15. More specifically, by reference to Fig. 1, nitride semiconductor crystal 11 fixed on a crystal holder 12 is pressed against a surface plate 14 fixed on a rotation axis 13 with processing solution 15 interposed therebetween, and rotation axis 13 is rotated to move surface plate 14 relative to nitride semiconductor crystal 11 to process the surface of the nitride semiconductor crystal.

The surface plate used in the present invention is not specifically limited. As an example, a surface plate A 24 as shown in Fig. 2, which has a flat surface for processing a crystal surface, or a surface plate B 34 as shown in Fig. 3, which has a surface having grooves formed thereon for processing a crystal surface, is preferably used. Though a depth D, a width W and a pitch P of the groove of the surface plate B are not specifically limited, depth D of 0.5-3 mm, width W of 0.5-3 mm, and pitch P of 1-5 mm are preferred.

The "liquid containing Na, Li or Ca" described here means a liquid containing Na or a Na compound such as Na, $NaNH_2$ or NaX (X indicates a halogen element such as I, Br or Cl, which is the same in the following), a liquid containing Li or a Li compound such as Li, $LiNH_2$ or LiX, or a liquid containing Ca or a Ca compound such as Ca or $CaX_2$, which also includes a liquid containing two or more elements ofNa, Li and Ca.

Nitrogen (N) in the nitride semiconductor crystal is dissolved into the liquid containing Na, Li or Ca, and thereby the surface of the nitride semiconductor crystal is etched. When a GaN crystal as one of the nitride semiconductor crystal is brought into contact with liquid Na, for example, a surface of the GaN crystal is etched with a reaction expressed as the following formula (1).

$$GaN + 3Na \rightarrow Ga^{3+} + N^{3-} + 3Na^+ + 3e^- \tag{1}$$

In the method of processing a surface of a nitride semiconductor crystal according to the present invention, the processing solution may be a liquid containing at least Na, which can have an Na content of 5-95 mol%. When Li or Ca is added to Na in the processing solution, an amount of dissolved nitride semiconductor crystal into the processing solution increases, and thus a processing speed increases.

When Li is added to Na, the Na content in the processing solution is preferably 5-60 mol%, and more preferably 10-50 mol% in terms of increasing the processing speed. When Ca is added to Na, the Na content in the processing solution is preferably 20-95 mol%, and more preferably 50-90 mol% in terms of increasing the processing speed.

In addition, in the method of processing a surface of a nitride semiconductor crystal according to the present invention, the processing solution is preferably a liquid containing at least Li in terms of increasing the processing speed. A Li content in the processing solution is preferably 5-100 mol%, more preferably 30-100 mol%, and further preferably 50-100 mol%.

In addition, in the method of processing a surface of a nitride semiconductor crystal according to the present invention, a processing temperature is preferably at least a melting point and at most a boiling point of the processing solution, and more preferably at least a temperature 100 °C higher than the melting point and at most a temperature 100 °C lower than the boiling point of the processing solution. When a temperature of the processing solution is at least a temperature 100 °C higher than the melting point, an amount of nitrogen dissolved into the processing solution increases, and when the temperature is at most a temperature 100 °C lower than the boiling point, evaporation of the processing solution is decreased, which enables efficient utilization of the processing solution.

Table 1 shows melting points and boiling points of various liquids used as the processing solution, each containing Na, Li or Ca. The melting point and boiling point of the processing solution are determined according to composition of the processing solution, and then the processing temperature can be determined as appropriate according to the viewpoint as described above.

Table 1

| Processing Solution | Melting Point (°C) | Boiling Point (°C) |
|---|---|---|
| Na | 97.7 | 892 |
| Li | 186 | 1609 |

Table 1   (continued)

| Processing Solution | Melting Point (°C) | Boiling Point (°C) |
|---|---|---|
| Ca | 850 | 1200 |
| $NaNH_2$ | 210 | 400 |
| NaI | 651 | 1300 |
| NaBr | 747 | 1390 |
| NaCl | 801 | 1413 |
| $LiNH_2$ | 374 | 430 |
| LiI | 446 | 1191 |
| LiBr | 500 | 1265 |
| LiCl | 605 | 1325-1360 |
| LiF | 848 | 1681 |
| $CaI_2$ | 740 | 1100 |
| $CaBr_2$ | 730 | 810 |
| $CaCl_2$ | 772 | >1600 |

The method of processing a surface of a nitride semiconductor crystal according to the present invention can be preferably applied to processing of a surface of an $Al_xGa_yIn_{1-x-y}N$ semiconductor crystal ($0 \le x \le 1$, $0 \le y \le 1$, $0 \le x + y \le 1$). The method can be widely applied to the nitride semiconductor crystal having nitrogen as an element of the crystal, regardless of Al, Ga and In contents.

With the above-described method of processing a surface of a nitride semiconductor crystal, the nitride semiconductor crystal having a maximum depth of a surface scratch of at most 0.01 μm can be obtained. Since the method of processing described above only uses a chemical method rather than a physical method of cutting or polishing with abrasive grains, the surface scratch due to friction between the abrasive grains and the crystal surface is not generated.

In addition, with the above-described method of processing a surface of a nitride semiconductor crystal, the nitride semiconductor crystal having an average thickness of a damaged layer of at most 2 μm can be obtained. Since the method of processing described above only uses a chemical method rather than a physical method of cutting or polishing with abrasive grains, the damaged layer due to friction between the abrasive grains and the crystal surface is not generated.

The method of processing a surface of a nitride semiconductor crystal according to the present invention and the nitride semiconductor crystal obtained with the method will be described specifically with examples.

(Example 1)

Referring to Figs. 1 and 2, surface plate A 24 shown in Fig. 2 was used as surface plate 14 shown in Fig. 1, and a metal Na of 100 % purity was placed on surface plate A 24 fixed on rotation axis 13. Then a temperature was increased to 800 °C to form processing solution 15 as liquid Na. Surface plate A 24 was rotated at 50 rpm for 1 hour while a GaN crystal as nitride semiconductor crystal 11 mounted on crystal holder 12 was pressed against a surface thereof with processing solution 15 to process a surface of the GaN crystal. A depth of a surface scratch of the processed GaN crystal was measured with a contact type surface profiler. In addition, a thickness of a damaged layer of the processed GaN crystal was estimated with CL (cathode luminescence) of a cross section of the crystal. A maximum depth of a surface scratch of the processed GaN crystal was 0.05 μm and an average thickness of a damaged layer was 1.5 μm. The result is summarized in Table 2.

(Comparative Example 1)

A processing device similar to that in example 1 was used in a room temperature. While free abrasive grains each made of SiC and having a diameter of 10 μm were supplied onto a surface of the surface plate and while the GaN crystal as the nitride semiconductor crystal mounted on the crystal holder was pressed against the surface of the surface plate supplied with the free abrasive grains, the surface plate was rotated at 50 rpm for 10 hours to process a surface of the GaN crystal. A maximum depth of a surface scratch of the processed GaN crystal was 5 µm and an average thickness of a damaged layer was 10 µm. The result is summarized in Table 2.

(Comparative Example 2)

A surface of the GaN crystal was processed in a similar condition as in comparative example 1 except that free abrasive grains of 5 µm were used. The result is summarized in Table 2.

(Example 2)

A surface of the GaN crystal was processed in a similar condition as in example 1 except that a processing time of the crystal surface was set to 5 hours. As a result, a maximum depth of a surface scratch was smaller than 0.01 µm, that is, below sensitivity of measurement, and an average thickness of a damaged layer was smaller than 1 µm, that is, below sensitivity of measurement. The result is summarized in Table 2.

(Example 3)

A surface of the GaN crystal was processed in a similar condition as in example 2 except that Na of 90 % purity was used as a processing solution. The result is summarized in Table 2. It is to be noted that, Fe, Mg, Ti, Sc, and V were detected as impurities included with Na as a result of measurement with glow discharge mass spectrometry.

(Examples 4-6)

A surface of the GaN crystal was processed using a processing solution as shown in Table 2 and with processing temperature and time as shown in Table 2. The result is summarized in Table 2.

(Examples 7-14)

A surface of the GaN crystal was processed using a processing solution as shown in Table 3 and with processing temperature and time as shown in Table 3. The result is summarized in Table 3.

(Example 15)

A surface of the GaN crystal was processed in a similar condition as in example 1 except that surface plate B 34 having grooves formed on a processing surface as shown in Fig. 3 was used as a surface plate. The groove of the surface plate B used in this example had depth D of 1 mm, width W of 1 mm and pitch P of 2 mm The result is summarized in Table 4.

(Examples 16-18)

A surface of the GaN crystal was processed in a similar condition as in example 1 except that processing temperature and time were changed as shown in Fig. 4. The result is summarized in Table 4.

(Examples 19-22)

A surface of each kind of crystal was processed in a similar condition as in example 2 except that the crystal to be processed is replaced with a crystal as shown in Fig. 4. The result is summarized in Table 4.

Table 2

| | | Comparative Example 1 | Comparative Example 2 | Example 1 | Example 2 | Example 3 | Example 4 | Example 5 | Example 6 |
|---|---|---|---|---|---|---|---|---|---|
| Nitride Semiconductor Crystal | | GaN | GaN | GaN | GaN | GaN | GaN | GaN | GaN |
| Method of Processing | | Abrasive Grain | Abrasive Grain | Surface Plate A | Surface Plate A | Surface Plate A | Surface Plate A | Surface Plate A | Surface Plate A |
| Diameter of Abrasive Grain ($\mu$m) | | 10 | 5 | - | - | - | - | - | - |
| Processing Solution | | - | - | Na | Na | Na | Li | Ca | Li |
| Chemical Composition of Processing Solution (Mol%) | Na | - | - | 100 | 100 | 90 | - | - | - |
| | Li | - | - | - | - | - | 100 | - | 100 |
| | Ca | - | - | - | - | - | - | 100 | - |
| | Impurity | - | - | - | - | 10* | - | - | - |
| Processing Condition | Temperature (°C) | Room Temperature | Room Temperature | 800 | 800 | 800 | 800 | 950 | 800 |
| | Time (hr) | 10 | 10 | 1 | 5 | 5 | 5 | 5 | 2 |
| Maximum Depth of Surface Scratch ($\mu$m) | | 5 | 2 | 0.05 | < 0.01 | < 0.01 | < 0.01 | < 0.01 | < 0.01 |
| Average Thickness of Damaged Layer ($\mu$m) | | 10 | 8 | 1.5 | < 1 | < 1 | < 1 | < 1 | < 1 |

*Mg, Fe, V, Sc, and Ti as impurities

EP 1 560 261 A1

Table 3

| | Example 7 | Example 8 | Example 9 | Example 10 | Example 11 | Example 12 | Example 13 | Example 14 |
|---|---|---|---|---|---|---|---|---|
| Nitride Semiconductor Crystal | GaN | GaN | GaN | GaN | GaN | GaN | GaN | GaN |
| Method of Processing | Surface Plate A | Surface Plate A | Surface Plate A | Surface Plate A | Surface Plate A | Surface Plate A | Surface Plate A | Surface Plate A |
| Diameter of Abrasive Grains (μm) | - | - | - | - | - | - | - | - |
| Processing Solution | Na-Li | Na-Li | Na-Ca | Na-Ca | Na-Li-Ca | Na-Li-Ca | Na-Li | Li-Ca |
| Chemical Composition of Processing Solution (Mol%) Na | 50 | 50 | 50 | 50 | 40 | 40 | 5 | - |
| Li | 50 | 50 | - | - | 30 | 30 | 95 | 95 |
| Ca | - | - | 50 | 50 | 30 | 30 | - | 5 |
| Impurity | - | - | - | - | - | - | - | - |
| Processing Condition Temperature (°C) | 800 | 800 | 800 | 800 | 800 | 800 | 800 | 800 |
| Time (hr) | 5 | 4 | 5 | 3 | 5 | 4 | 2 | 2 |
| Maximum Depth of Surface Scratch (μm) | < 0.01 | < 0.01 | < 0.01 | < 0.01 | < 0.01 | < 0.01 | < 0.01 | < 0.01 |
| Average Thickness of Damaged Layer (μm) | < 1 | < 1 | < 1 | < 1 | < 1 | < 1 | < 1 | < 1 |

Table 4

| | Example 15 | Example 16 | Example 17 | Example 18 | Example 19 | Example 20 | Example 21 | Example 22 |
|---|---|---|---|---|---|---|---|---|
| Nitride Semiconductor Crystal | GaN | GaN | GaN | GaN | AlN | $Al_{0.5}Ga_{0.5}N$ | InN | $In_{0.5}Ga_{0.5}N$ |
| Method of Processing | Surface Plate B | Surface Plate A | Surface Plate A | Surface Plate A | Surface Plate A | Surface Plate A | Surface Plate A | Surface Plate A |
| Diameter of Abrasive Grains (μm) | - | - | - | - | - | - | - | - |
| Processing Solution — Chemical Composition of Processing Solution (Mol%) — Na | Na 100 | Na 100 | Na 100 | Na 100 | Na 100 | Na 100 | Na 100 | Na 100 |
| Li | - | - | - | - | - | - | - | - |
| Ca | - | - | - | - | - | - | - | - |
| Impurity | - | - | - | - | - | - | - | - |
| Processing Condition — Temperature (°C) | 800 | 300 | 600 | 1000 | 800 | 800 | 800 | 80 |
| Time (hr) | 1 | 20 | 10 | 3 | 5 | 5 | 5 | 5 |
| Maximum Depth of Surface Scratch (μm) | <0.01 | <0.01 | <0.01 | <0.01 | <0.01 | <0.01 | <0.01 | <0.01 |
| Average Thickness of Damaged Layer (μm) | <1 | <1 | <1 | <1 | <1 | <1 | <1 | <1 |

It is obvious from example 1 in comparison with comparative example 2 that, with Na used as one of the processing solutions of the present invention in place of the abrasive grains having a diameter of 5 μm, the maximum depth of the surface scratch and the average thickness of the damaged layer were substantially decreased from 2 μm to 0.05 μm and from 8 μm to 1.5 μm, respectively. In addition, it is obvious from example 2 in comparison with example 1 that, by changing the processing time from 1 hour to 5 hours at a temperature of 800 °C, the maximum depth of the surface scratch less than 0.01 μm and the average thickness of the damaged layer less than 1 μm were attained and thus surface processing with an extremely high accuracy was enabled.

In addition, as shown in examples 4-8, highly accurate surface processing with the maximum depth of the surface scratch less than 0.01 μm and the average thickness of the damaged layer less than 1 μm is also possible using Li or Ca in place of or in combination with Na as the processing solution. In particular, as shown in examples 6, 8, 10, and 12-14, the processing speed is increased and the processing time can be decreased when the processing solution containing at least Li is used. In addition, as is obvious from example 9 in comparison with example 2, the processing time can be decreased from 5 hours to 1 hour when the surface plate having the grooves on the processing surface is used in place of the surface plate having a flat processing surface. In addition, as shown in examples 10-12, highly accurate surface processing with the maximum depth of the surface scratch less than 0.01 μm and the average thickness of the damaged layer less than 1 μm is enabled by setting the processing time to 20-3 hours as appropriate for the processing temperature of 300-1000 °C. Furthermore, as shown in examples 13-16, the crystal to be processed is not limited to the GaN crystal, and highly accurate surface processing of each kind of nitride semiconductor crystal such as an AlN crystal, an AlGaN crystal, an InN crystal, or an InGaN crystal is also possible.

It should be understood that the mode and examples disclosed herein are illustrative and non-restrictive in every respect. The scope of the present invention is defined by the terms of the claims, rather than the description above, and is intended to include any modifications and changes within the scope and meaning equivalent to the terms of the claims.

Industrial Applicability

As described above, the present invention can be applied widely to a method of processing a surface of a nitride semiconductor crystal with a decreased depth of a surface scratch or a decreased thickness of a damaged layer, and a nitride semiconductor crystal obtained with the method.

**Claims**

1.　A method of processing a surface of a nitride semiconductor crystal, wherein
　　　a surface of a nitride semiconductor crystal (11) is brought into contact with a liquid containing at least Na, Li or Ca as a processing solution (15).

2.　The method of processing a surface of a nitride semiconductor crystal according to claim 1, wherein
　　　said processing solution (15) is a liquid containing at least Na and has an Na content of 5-95 mol%.

3.　The method of processing a surface of a nitride semiconductor crystal according to claim 1, wherein
　　　said processing solution (15) is a liquid containing at least Li and has an Li content of 5-100 mol%.

4.　The method of processing a surface of a nitride semiconductor crystal according to claim 1, wherein
　　　said nitride semiconductor crystal (11) is an $Al_xGa_yIn_{1-x-y}N$ semiconductor crystal ($0 \leq x \leq 1$, $0 \leq y \leq 1$, $0 \leq x + y \leq 1$).

5.　A nitride semiconductor crystal having a maximum depth of a surface scratch of at most 0.01 μm and obtained with a method of processing a surface of a nitride semiconductor crystal wherein a surface of a nitride semiconductor crystal (11) is brought into contact with a liquid containing at least Na, Li or Ca as a processing solution (15).

6.　The nitride semiconductor crystal according to claim 5, wherein
　　　said processing solution (15) is a liquid containing at least Na and has an Na content of 5-95 mol%.

7.　The nitride semiconductor crystal according to claim 5, wherein
　　　said processing solution (15) is a liquid containing at least Li and has an Li content of 5-100 mol%.

8.　The nitride semiconductor crystal according to claim 5, wherein
　　　said nitride semiconductor crystal (11) is an $Al_xGa_yIn_{1-x-y}N$ semiconductor crystal ($0 \leq x \leq 1$, $0 \leq y \leq 1$, $0 \leq x + y \leq 1$).

9.　A nitride semiconductor crystal having an average thickness of a damaged layer of at most 2 μm and obtained with a method of processing a surface of a nitride semiconductor crystal wherein a surface of a nitride semiconductor crystal (11) is brought into contact with a liquid containing at least Na, Li or Ca as a processing solution (15).

10.　The nitride semiconductor crystal according to claim 9, wherein
　　　said processing solution (15) is a liquid containing at least Na and has an Na content of 5-95 mol%.

**11.** The nitride semiconductor crystal according to claim 9, wherein
said processing solution (15) is a liquid containing at least Li and has an Li content of 5-100 mol%.

**12.** The nitride semiconductor crystal according to claim 9, wherein
said nitride semiconductor crystal (11) is an $Al_xGa_yIn_{1-x-y}N$ semiconductor crystal ($0 \leq x \leq 1$, $0 \leq y \leq 1$, $0 \leq x + y \leq 1$).

FIG.1

FIG.2

FIG.3

| | **INTERNATIONAL SEARCH REPORT** | International application No. |
|---|---|---|
| | | PCT/JP2004/008090 |

**A. CLASSIFICATION OF SUBJECT MATTER**
Int.Cl⁷ H01L21/306, C30B33/10

According to International Patent Classification (IPC) or to both national classification and IPC

**B. FIELDS SEARCHED**

Minimum documentation searched (classification system followed by classification symbols)
Int.Cl⁷ H01L21/306, C30B33/10

Documentation searched other than minimum documentation to the extent that such documents are included in the fields searched
Jitsuyo Shinan Koho        1922–1996   Toroku Jitsuyo Shinan Koho   1994–2004
Kokai Jitsuyo Shinan Koho   1971–2004   Jitsuyo Shinan Toroku Koho   1996–2004

Electronic data base consulted during the international search (name of data base and, where practicable, search terms used)
JOIS

**C. DOCUMENTS CONSIDERED TO BE RELEVANT**

| Category* | Citation of document, with indication, where appropriate, of the relevant passages | Relevant to claim No. |
|---|---|---|
| X | WO 2002/101121 A1 (ADVANCED TECHNOLOGY MATERIALS, INC.), 19 December, 2002 (19.12.02), Claim 67 & US 6488767 B1 | 1–12 |
| X | JP 1-204425 A (Toyota Central Research And Development Laboratories, Inc.), 17 August, 1989 (17.08.89), Page 1, lower right column, lines 13 to 15 (Family: none) | 1,2,4–6, 8–10,12 |
| A | J.L. Weyher, et al., Chemical polishing of bulk and epitaxial GaN, Journal of Crystal Growth, 182 (1997), pages 17 to 22 | 1–12 |

☐ Further documents are listed in the continuation of Box C.      ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 03 September, 2004 (03.09.04) | 21 September, 2004 (21.09.04) |

| Name and mailing address of the ISA/ | Authorized officer |
|---|---|
| Japanese Patent Office | |
| Facsimile No. | Telephone No. |

Form PCT/ISA/210 (second sheet) (January 2004)